(19) Europäisches Patentamt
European Patent Office
Office européen des brevets

(11) **EP 4 350 910 A1**

(12) **EUROPEAN PATENT APPLICATION**
published in accordance with Art. 153(4) EPC

(43) Date of publication:
**10.04.2024 Bulletin 2024/15**

(21) Application number: **22816107.1**

(22) Date of filing: **31.05.2022**

(51) International Patent Classification (IPC):
***H01S 5/343*** *(2006.01)*

(52) Cooperative Patent Classification (CPC):
**H01S 5/343**

(86) International application number:
**PCT/JP2022/022136**

(87) International publication number:
**WO 2022/255361 (08.12.2022 Gazette 2022/49)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **01.06.2021   JP 2021092638**

(71) Applicant: **RIKEN**
**Wako-shi, Saitama 351-0198 (JP)**

(72) Inventors:
• **WANG, Li**
**Wako-shi, Saitama 351-0198 (JP)**
• **HIRAYAMA, Hideki**
**Wako-shi, Saitama 351-0198 (JP)**
• **LIN, Tsung-Tse**
**Wako-shi, Saitama 351-0198 (JP)**

(74) Representative: **Huebner, Stefan Rolf**
**Postfach 101317**
**80087 München (DE)**

(54) **QUANTUM CASCADE LASER ELEMENT**

(57)    To increase the ceiling of operating temperature of quantum cascade lasers in THz range, the quantum cascade laser element 1000 of the present disclosure has a semiconductor superlattice structure with an active region 100 that emits electromagnetic waves of a certain frequency in the THz range under the external voltage applied through a pair of electrodes for operation. The quantum well structure of the unit structure 10U that comprises this semiconductor superlattice structure has quantum levels of electrons in an isolated three-level structure. In one example, each unit structure has a two-quantum well structure having a first well layer 10W1 and a second well layer 10W2, which are separated from each other by a barrier layer, the first well layer including a first sublayer 10W11, a second sublayer 10W12 with a composition different from that of the first sublayer, and a third sublayer 10W13, which has the same composition as the first sublayer.

*FIG. 3A*

EP 4 350 910 A1

**FIG. 3B**

**Description**

Technical Field

The present disclosure relates to a quantum cascade laser element. More specifically, the present disclosure relates to a quantum cascade laser element that emits electromagnetic waves in the terahertz range.

Background Art

Recently, quantum cascade lasers (QCLs) have attracted attention as solid-state light sources that radiates (emit) electromagnetic waves in the mid-infrared and terahertz (THz) ranges. QCL devices have a semiconductor superlattice structure that contains repeating unit structures, and there are generally multiple wells and barriers in each unit structure for the potentials acting on the electrons inside. When an external voltage is applied for operating the QCL elements, the potential indicating the wells and barriers in the semiconductor superlattice structure is generally tilted as a function of their positions in thickness. Electrons serving as carriers are transported through the subbands, or levels, formed in the tilted and uneven potentials, and undergo inter-subband transitions repeatedly, resulting in stimulated emission of electromagnetic waves and lasing operation. The term "cascade" is so named because of the behavior of electrons that are transported while losing energy through transitions between subbands. In QCL elements, it is possible to select a wavelength independent of the energy gap of the semiconductor superlattice material for the operation as a laser (lasing). The lasing wavelength is adjustable according to the design of the semiconductor superlattice structure. Therefore, QCL elements are attracting attention for use as coherent light sources in the mid-infrared and terahertz (THz) ranges, which are wavelengths (frequency ranges) where solid-state light sources have not been available to date.

Electromagnetic waves in the THz range, or THz-waves, have both optical and radio wave properties and are expected to be applied, for example, to the identification of substances by transmission and to scanning examination of human bodies. To improve their practicality, THz-wave QCL (THz-QCL) elements that are capable of producing stimulated emission at the desired frequency have been considered promising candidates. THz-QCL elements requires "band engineering," in which the semiconductor superlattice structure is fabricated with precisely designed well and barrier layer thicknesses while taking the gradient caused by the electric field and the physical mechanism into consideration.

The upper limit of the temperature range at which lasing operation can be performed (hereinafter referred to as the "ceiling of operating temperature") is an indicator of the practicality of THz-QCL. In particular, the world's highest ceiling of operating temperature for THz-QCL elements is only 250 K (-23.15 °C) (Non-Patent Document 1). In this report, authors adopt a quantum well structure that has a clean three-level system. Such a system barely reaches the temperature range reachable by Peltier electron cooling (230 K, or about -43 °C or higher), however it does not perform lasing operation at room temperature (e.g., 300 K, or about 27 °C). There is no THz-QCL element that can operate at room temperature.

In contrast, the inventors of this application analyzed the conditions for high-temperature operation in detail based on a theoretical calculation method called the NEGF method (nonequilibrium Green's function method), which provides reliable prediction results for conduction phenomena, based on an idea different from the operation of THz-QCL with the above structure. As a result, the factors that determine the ceiling of operating temperature were studied and disclosed (see Patent Document 1). In the study, the following two factors were found to be related to the ceiling of operating temperature.

(1) Inhibition of the population inversion due to the stagnation of electrons in the injection level.
(2) The tendency for electrons to leak as a result of relatively high probability of finding in multiple levels located downstream in the electron stream that have higher energies than the upper lasing level.

With these points in mind, the inventors have created a THz-QCL structure that has two quantum wells in a unit structure and employs a semiconductor superlattice structure in which the symmetry of the material, or of the potential structure, is intentionally degraded in the two quantum wells. The THz-QCL employing that semiconductor superlattice structure can operate at a maximum temperature of about 260 K in 3.5 - 4 THz and 300 K (about 27°C) at 1.54 THz.

Efforts to achieve high-temperature operation using a similar NEGF method for THz-QCL operation analysis have also been reported by another group (Non-Patent Document 2) .

Citation List

Patent Document

Patent Document 1: JP 2019-153652

Non-Patent Document

Non-Patent Document 1: Khalatpour, A., Paulsen, A.K., Deimert, C. et al. "High-power portable terahertz laser systems", Nature Photonics 15, 16-20 (2021); Published 02 November 2020; https://doi.org/10.1038/s41566-020-00707-5
Non-Patent Document 2: L. Bosco, M. Franckie, G. Scalari, M. Beck, A. Wacker, and J. Faist, "Thermoelectrically cooled THz quantum cascade laser operating up to 210K", Appl. Phys. Lett. 115, 010601 (2019); Published Online: 1 July 2019; doi: 10.1063/1.5110305

Summary of Disclosure

Technical Problem

However, there are many factors that need to be clarified, such as what mechanism determines the ceiling of operating temperature at which THz-QCL elements can perform lasing, and what conditions can increase the ceiling of operating temperature, thus further study is needed. Specifically, an effective approach to realize THz-QCL elements that perform at or above room temperature has not been clarified. The present disclosure solves at least one of the problems mentioned above. The present disclosure contributes to the development of various applications employing THz-QCL elements by raising the ceiling of operating temperature at which lasing operation is performed in quantum cascade laser elements that operate in the THz range.

Solution to Problem

The inventors of this application have conceived of an operating mechanism that could contribute to the high-temperature operation of THz-QCL elements, and then analyzed it in detail by utilizing the NEGF method. We performed extensive investigations on the structure of THz-QCL elements and found that the problems mentioned above could be overcome by implementing a new electron subband structure called an isolated three-level structure, and thus completed the invention of this application. Furthermore, we have also completed the invention of the present application by creating specific structure for implementing the isolated three-level structure.
That is, in certain aspects of the present disclosure provided is a quantum cascade laser element having a semiconductor superlattice structure sandwiched between a pair of electrodes, wherein the semiconductor superlattice structure has an active region that emits electromagnetic waves of a certain frequency in the THz region under an external voltage applied through the pair of electrodes for operation, wherein the active region has a plurality of unit structures that are stacked repeatedly, wherein each unit structure has a quantum well structure comprising a plurality of well layers separated from each other by a barrier layer, and wherein the quantum well structure has a subband structure of electrons in an isolated three-level structure under the external voltage.
In the quantum cascade laser element, it is preferred that the above mentioned quantum cascade laser element, wherein the isolated three-level structure in each unit structure includes an upper lasing level, a lower lasing level, and an injection level under the external voltage, and wherein a selective electron injection operation from the injection level to the upper lasing level by vertical indirect injection via LO phonon scattering is performed under the external voltage.
Furthermore, in the certain aspects of the present disclosure provided also is a quantum cascade laser element having a semiconductor superlattice structure sandwiched between a pair of electrodes, wherein the semiconductor superlattice structure has an active region that emits electromagnetic waves of a certain frequency in the THz range under the external voltage applied through the pair of electrodes for operation, wherein the active region has a plurality of unit structures that are stacked repeatedly, Wherein each unit structure has a two-quantum well structure including a first well layer and a second well layer separated from each other by a barrier layer in the order of electron flow under the external voltage, and wherein the potential for electrons in at least one of the first well layer or the second well layer is modulated according to the position in the thickness direction.
It is also preferred that, regarding the modulation, the above-mentioned quantum cascade laser element, wherein the first well layer includes a structure in which a first sublayer, a second sublayer of different composition from the first sublayer, and a third sublayer of the same composition as the first sublayer are stacked in the order of electron flow under the external voltage, and wherein the potential for electrons in the second sublayer is lower than the barrier height created by the potential for electrons in the barrier layer and higher than the potential for electrons in both the first sublayer and the third sublayer, and wherein the potential for electrons in the first well layer has a convex structure.
Furthermore, it is also preferred that the above-mentioned quantum cascade laser element, wherein an isolated three-level structure is realized under the external voltage, the isolated three-level structure including an upper lasing level, a lower lasing level, and an injection level, wherein the upper lasing level of each unit structure is a ground state of the first well layer, where wherein the lower lasing level and the injection level of each unit structure are a ground state of the second well layer and a first excited state of a first well layer in the next unit structure downstream for electrons under the external voltage.

In this application, electromagnetic waves in the THz range refer to electromagnetic waves in the frequency range of approximately 0.1 THz to 30 THz, i.e., in the wavelength range of about 10 um to 3 mm. The "low frequency THz range" refers to the frequency range of 2.0 THz or lower in the above THz range. Furthermore, in the description of this application, the structure and functions of elements may be described using technical terms diverted or borrowed from the fields of electronic devices and physics that deal with visible light and infrared rays. For this reason, even in descriptions regarding electromagnetic waves in the frequency or wavelength range far away from visible light, the terms "laser" and "luminescence," "optical-" (optical-), and "light-" (photo-), and other terms may be used. The term "room temperature" in this application document is intended to refer to 300 K (approx. 27 °C) as an example if not otherwise mentioned, but this is not intended to be a limitation. In the description regarding semiconductor engineering fields such as quantum wells and semiconductor superlattices, terms in the field of quantum mechanics, such as ground state and first excited state, are also used when appropriate. For example, the ground state, first excited state, second excited state, and other states with quantized energies of electrons in a quantum well refer to the quantum mechanical levels of electrons that are bound and generally quantized in a one-dimensional quantum well, also called a subband in the QCL element.

Advantageous Effects of Disclosure

In the quantum cascade laser element provided in any of the aspects of the present disclosure, lasing operation is realized at a higher operating temperature than before.

Brief Description of Drawings

FIGS. 1A and 1B illustrate the mechanism of operation based on the quantum levels of the electrons in the isolated three-level structure of the THz-QCL element in embodiments of the present disclosure.

FIGS. 2A-2C are a diagram (FIG. 2A), an enlarged cross-sectional view (FIG. 2B), and a further partially enlarged cross-sectional view (FIG. 2C) showing an overview of the structure of the THz-QCL element in an embodiment of the present disclosure.

FIGS. 3A and 3B are schematic illustrations of the potential and electron subband structures, respectively, showing the conventional THz-QCL structure for high temperature (two-quantum well type) and the structure of an embodiment (modified two-quantum well type).

FIG. 4A and B are the wave function and the conduction band profile of the subband state of the THz-QCL during operation in the conventional structure and the structure of an embodiment of the present disclosure, respectively.

FIGS. 5A and B are distribution maps of current density analyzed by theoretical calculation for the conventional structure and the structure of an embodiment of the present disclosure, respectively.

FIG. 6A shows a schematic of the diagonal transition in an embodiment of the present disclosure. FIG. 6B is a calculated temperature dependence of the LO phonon scattering relaxation time of the upper lasing level in an embodiment of the present disclosure.

FIGS. 7A-C show the temperature dependence of the population of electrons for the upper lasing level ULL and the lower lasing level LLL when the oscillator strength is varied from 0.18, 0.4, and 0.6 in an embodiment of the present disclosure. FIG. 7D is another plot of the calculated values in FIGS. 7A-C, focusing on the difference in the population of electrons in the upper lasing level ULL and the lower lasing level LLL as a function of temperature.

FIGS. 8A and B show the optical gain spectra for the conventional design for the THz-QCL structure for high temperature and for the design of an embodiment of the present disclosure. FIG. 8C shows dependence of optical gain on oscillator strength in an embodiment of the present disclosure.

FIG. 9 is a map showing optical gain in terms of shading as a function of photon frequency, determined from energy difference of lasing levels, and temperature, obtained for an oscillator strength of 0.18 in the design of an embodiment of the present disclosure.

FIG. 10 is a graph of the gain for a THz-QCL element of an embodiment of the present disclosure that employs a GaN-AlGaN material at various temperatures.

Description of Embodiments

The quantum cascade laser elements of the present disclosure are described below. Unless otherwise noted in the description, common parts or elements are marked with a common reference numeral. In addition, each element of each embodiment in the drawing should be understood as not being drawn to scale.

## 1. First Embodiment

This section describes an embodiment of the present disclosure. The following description for conventional ones refers to device structure and operation that have been experimentally confirmed in Non-Patent Document 1, unless otherwise noted.
The inventors have created a novel concept that can improve the ceiling of operating temperature range up to 340K, which was 230K in the conventional approach (Non-Patent Document 1). In the following, the concept is explained, especially from the viewpoint of design guidelines for the quantum structure of electrons (1-1), followed by a description of the specific device structure for the new concept (1-2) and analysis by numerical simulation (1-3). Furthermore, choice of materials will be explained (1-4), and other materials will be discussed (1-5) .

## 1-1. Design Guidelines for Quantum Structure of Electrons (Isolated Three-level Structure)

The lasing frequency of THz-QCL elements, or the energy of the emitted photons, is between 12 and 16 meV for the 3-4 THz frequency range. This range of values is smaller than the thermal energy of an electron (kT = 26 meV) at room temperature of 300K. Where k is Boltzmann's constant, also known as $k_B$, and T is the absolute temperature. Thus, one of the factors that greatly affects the possibility of lasing at room temperature is the presence or absence of a thermally excited leakage channel for the electrons. In THz-QCL elements using AlGaAs-GaAs semiconductors, there is an extraordinarily strong absorption band at 36 meV (9 THz) due to electron-LO phonon scattering, which is a problem. To achieve room temperature operation, it is necessary to block all the above leakage channels as much as possible. Based on this concept, we propose in this embodiment an isolated three-level structure in which the quantum levels (three levels) of the electrons involved in the operation are isolated as much as possible from the other levels.

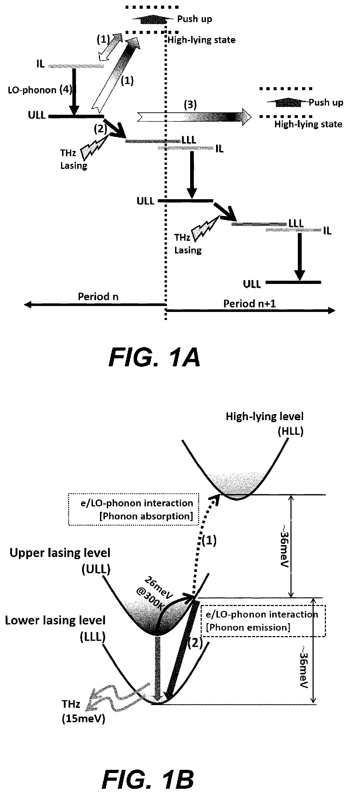

FIGS. 1A and 1B show the mechanism of operation based on the quantum levels of the electrons in the isolated three-level structure of the THz-QCL element of this embodiment. In order to obtain the optical gain required for lasing, it is necessary to obtain an optical gain required for oscillation at room temperature. To achieve this optical gain, it is necessary to efficiently perform and maintain a population inversion between the upper lasing level (ULL) and the lower lasing level (LLL) even at room temperature. Specifically, it is important to satisfy the following three conditions simultaneously.

(Condition 1) Selective Injection of Electrons into the Upper Lasing Level (FIG. 1A: (4) Vertical Indirect Injection)

The basic structure utilizes selective injection of electrons from the injection level (IL) to the upper lasing level ULL by vertical indirect injection via LO phonon scattering. FIG. 1A illustrates the concept of the present embodiment by transitions and transfers of electrons between quantum levels, shown with the stacking direction of the semiconductor superlattice on the horizontal axis and the energy on the vertical axis, and FIG. 1B illustrates the energy bands in wavenumber space. The vertical indirect injection from the injection level IL to the upper lasing level ULL is indicated by the arrow attached to the LO phonon (4). In the conventional method, electrons are injected to the upper lasing level ULL by tunneling injection, which exploits phenomena such as resonant tunneling that tunnels a quantum barrier. In such devices, electrons are injected into the upper lasing level ULL with positional migration (electron flow), and at room temperature there is an energy broadening of the electrons in the injected level due to thermal agitation. As a result, the simultaneous injection of electrons into the upper lasing level and the lower lasing level cannot be avoided, which hinders the maintenance of the population inversion. In contrast, the present embodiment eliminates this phenomenon by using an indirect injection mechanism. The term "indirect" here refers to the injection of electrons from the injection level IL, which has a difference in energy value, to the upper lasing level ULL via scattering by LO phonons. In the present embodiment, the LO phonon scattering process also serves to extract electrons from the lower lasing level LLL at high speed. Since the ideal population inversion can be maintained at high temperature by using such a three-level mechanism, room-temperature operation can become a reality in this embodiment.

(Condition 2) Blocking leakage channels to adjacent levels (isolation of the three levels)

In the present embodiment, the three levels in question are isolated from other levels adjacent to the three levels. That is, the leakage channels associated with the upper lasing level ULL, the injection level IL, and the lower lasing level LLL are blocked. The blocking is achieved by blocking leakage channels to an upper leakage level (high-lying state or high-lying level: HLL), which is one of adjacent levels other than the three levels, and by blocking channels (horizontal leakage channels) due to tunneling to a level belonging to another unit structure, which is also one of the adjacent levels and is positionally distant from the three levels. The leakage to the upper leakage level is path (1) in FIG. 1A and FIG. 1B. To block it, it is useful to push up the upper lasing level by making the energy difference from the upper lasing level to the upper leakage level higher than that for an AlGaAs-GaAs semiconductor superlattice structure, e.g., 62 meV or higher. The value of 62 meV is obtained from 26 meV (room temperature kT) + 36 meV (LO phonon absorption energy of the AlGaAs-GaAs system). The horizontal leakage channel is path (3) in FIG. 1A. To block it, the thickness of the barrier between the two unit structures (i.e., the barrier upstream of the well layer where the amplitude of the upper lasing level (ULL) wave function is large, or the injection barrier) can be adjusted. The upper leakage level in the downstream unit structure may form a horizontal leakage channel, and pushing up the upper leakage level also helps to block the horizontal leakage channel (FIG. 1A).

(Condition 3) Reduction of Thermally Excited Electron - LO Phonon Scattering (Optimization of Diagonal Transition of the Lasing Levels)

In the room temperature range, the following relationship applies.

```
26meV (room temperature kT) + 16meV (lasing energy (4
THz) = 42meV)
            > 36meV (LO phonon scattering energy for AlGaAs-
GaAs system)
```

Because of this relationship with LO phonons, leakage channels due to LO phonon scattering are easily generated between lasing levels (FIGS. 1A and 1B, path (2)). That is, since the difference between the upper oscillation level ULL and the lower lasing level LLL is the lasing energy, the sum of the thermal excitation and the lasing energy (left side of the above equation) exceeds the LO phonon energy with respect to the lower lasing level LLL, causing electrons to relax with a large relaxation rate (LO phonon scattering rate) unrelated to lasing. In order to reduce this LO phonon scattering rate, the wave functions of the upper lasing level, ULL, and the lower lasing level, LLL, are spatially separated in present embodiment. The optical transition between the upper lasing level ULL and the lower lasing level LLL with this spatial separation is called a diagonal transition. By choosing a combination of wavefunctions that leads to a diagonal transition, the scattering probability due to the LO phonon can be reduced. However, if the degree of diagonal transition is too large, the oscillator strength itself becomes small and the emission rate decreases. Therefore, in the present embodiment, the oscillator strength or the degree of diagonal transition is optimized to strike a balance between the emission rate and the LO phonon scattering rate. The inventors have confirmed that there is a clear optimum range for the oscillator strength (OS), and that by choosing the appropriate value, an optical gain that allows lasing even at room temperature can be achieved, which will be discussed below.

1-2. Device Structure (Modified Two-Quantum Well Type)

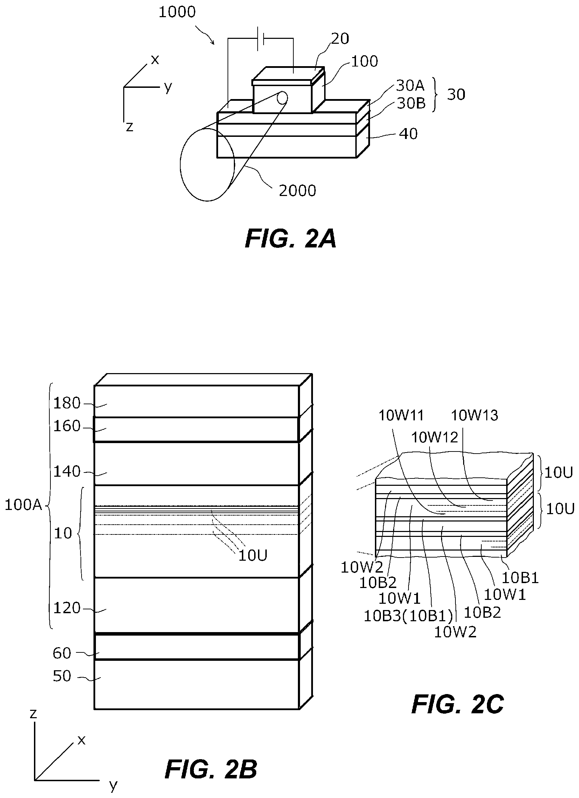

The structure of a THz-QCL element of the present embodiment for implementing the quantum structure of electrons in the above isolated three-level structure is described below.
The inventors have devised structural details of a THz-QCL element capable of implementing a quantum structure of electrons that satisfies the above three conditions. FIG. 2 shows a diagram (FIG. 2A), an enlarged cross-sectional view (FIG. 2B), and a further partially enlarged cross-sectional view (FIG. 2C) outlining the structure of the THz-QCL element including the present embodiment. A typical THz-QCL element 1000 (FIG. 2A) of the present embodiment generally has of a pair of electrodes 20 and 30 and a QCL structure 100, which is a semiconductor superlattice structure, sandwiched therebetween. The electrodes 20 and 30 are used to receive a voltage for forming an electric field to the QCL structure 100 and a current for emitting electromagnetic waves, i.e., light emission, from an external source. The electrodes 20 and 30 are typically made of metal, and when THz electromagnetic waves act on them, surface plasmons are induced, and the electrodes 20 and 30 also act to confine light due to the cavity structure. This structure is also called a double metal wave guide (DMW) structure. The electrodes 20 and 30 are not necessarily metal, and a structure in which one is a metal layer and the other is a high-conductivity semiconductor layer (one-sided metal waveguide structure) can be adopted, for example by making one of them a high-concentration n-doped layer The QCL structure 100 has an active region 10. The THz-QCL element 1000 is operated by allowing electrons to pass through the repeating structure of the potential of the electrons formed in the active region 10 in the direction of its thickness when the above-mentioned voltage is applied. During this passage, the element is operated to emit electromagnetic waves 2000 in the THz range as the electrons transition between subbands or levels. The THz-QCL element 1000 of FIG. 2 is fabricated by forming a metal layer 30B of the electrodes 30 on a receptor substrate 40 (hereinafter referred to as "receptor 40") and bonding it to a metal layer 30A formed on the QCL structure 100. In addition, the THz-QCL element 1000 of FIG. 2 also uses other layers for operation and device fabrication, such as the highly-doped GaAs layers 120 and 140, the $\delta$-doped GaAs layer 160, and the etch stopper layer 60, as appropriate.

The active region 10 (FIG. 2B) comprises a plurality of unit structures 10U of a certain thickness including a plurality of alternately stacked well layers 10W and barrier layers 10B, each unit structure 10U being repeatedly stacked in the thickness direction. In the semiconductor superlattice structure 100A shown in FIG. 2B, the active region 10 comprises a structure in which the same structure 10U is repeated and stacked for generally 10 to 200 cycles. FIG. 2C shows an enlarged view of the structure of each unit structure 10U for two units (two periods). Each unit structure 10U consists of two well layers 10W and two barrier layers 10B, and each well layer 10W is separated from the other by each barrier layer 10B. The individual well layers 10W are different from the first well layer 10W1 and the second well layer 10W2 in order from the substrate 50 side. The individual barrier layers 10B are also differentiated as necessary and are referred to as the first barrier layer 10B1 and the second barrier layer 10B2, in order from the substrate 50 side. The well layer 10W1 is disposed in contact with the barrier layer 10B1, and the barrier layer 10B2 is disposed in contact with the well layer 10W1. The same applies thereafter. The barrier layer 10B3 becomes the barrier layer 10B1 of the next unit structure 10U.

The first well layer 10W1 has a first sublayer 10W11, a second sublayer 10W12, and a third sublayer 10W13. The second sublayer 10W12 has a composition such that its potential is higher than those of the first sublayer 10W11 and the third sublayer 10W13 and lower than those of the first barrier layer 10B1 and the second barrier layer 10B2. This means that the potential forming the bottom of the first well layer 10W1 is modulated by the first to third sublayers 10W11 - 10W13 in the present embodiment.

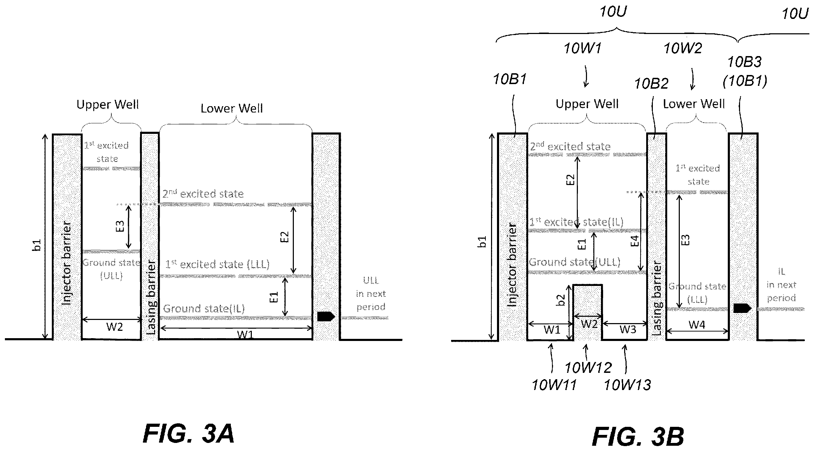

FIG. 3B is a schematic illustration of the potential and electron subband structure for the present embodiment (referred to as "modified two-quantum well configuration"), which is shown in contrast to the conventional THz-QCL structure for high temperature applications (two-quantum well configuration, FIG. 3A). In this figure, the slope of the bias electric field is omitted, the direction of electron flow is oriented from left to right as the position of the thickness of the stacked layers, and the potential and subbands are described with the higher energy values in the up direction for the vertical direction of the paper. In ideal operation at temperatures well below room temperature, only three levels are involved, producing optical transitions with THz emission across the lasing barrier. The upper lasing level, ULL, is the ground state of the well layer on the left side of the paper in both structures. In contrast, the lower lasing level, LLL, is the first excited state of the well on the right side of the paper in the two-quantum well configuration, while it is the ground state of the well on the right side of the paper in the modified two-quantum well configuration. The injection level IL is the ground state of the well on the right side of the paper in the two-quantum well system, while it is the first excited state of the first well layer on the left side of the paper in the modified two-quantum well system. In both configurations, LO phonon scattering is involved in the operation of the injection level IL, but in the two-quantum well configuration it is involved in the injection of electrons from the lower lasing level LLL in the well on the right side of the paper. In contrast, in the modified two-quantum well configuration, the injection level IL is involved in the process of injecting electrons into the upper lasing level ULL. To enable vertical LO phonon down-scattering, the energy spacing E1 is set to about 36 meV in FIG. 3B. This allows vertical indirect injection according to Condition 1 above. In the modified two-quantum well configuration, the first well layer 10W1 includes the first sublayer 10W11, the second sublayer 10W12, and the third sublayer 10W13, and a convex structure is formed in the potential of the first well layer 10W1.

In the present embodiment of the modified two-quantum well structure shown in FIG. 3B, the high-lying levels in Condition 2 described above include the second excited state of the first well layer 10W1 and the first excited state of the second well layer 10W2 in FIG. 3B. That is, the adjacent levels, except for the three levels for lasing and population inversion, are the high-lying levels. With respect to the above Condition 2, the level structure of the present embodiment has a large energy difference E4 from the upper lasing level ULL to the high-lying levels, which blocks leakage channels in the longitudinal direction, i.e., in the direction of electron flow. The equivalent energy difference in the conventional structure is E3 in FIG. 3A, which is small, allowing electrons to leak at room temperature.

Specifically, in the present embodiment, a small convex structure with a second sublayer 10W12 is provided in the potential within the injection quantum well to implement this quantum level arrangement. This is the modified two-quantum well configuration. By providing a small convex structure in the injection quantum well, it is possible to exert somewhat independent effects on the respective energy levels of the "even modes" and "odd modes" of the wave function. More specifically, the upper lasing level (ground level) and the high-lying level (second excited state) in the first well layer 10W1 are "odd modes" because they have an antinode of probability amplitude at the center of the first well layer 10W1. In contrast, the injection level (first excited state) is an even mode because the probability amplitude at the center of the injection level is a node. The convex structure of the potential in the second sublayer 10W12 has a stronger effect on the levels with antinode of probability amplitude at the position, i.e., odd-mode levels, than without the convex structure, while it has only a weak effect on the even-mode levels. For this reason, the convex structure of the potential through the second sublayer 10W12 makes it possible to reduce the energy interval E1 from the injection level (first excited state) to the upper lasing level ULL below it and to separate the energy interval E2 to the high-lying level (second excited state) above it. That is, the second sublayer 10W12 serves to adjust the relative positional arrangement of the levels with respect to the energy level structure due to the width and depth of the entire first well layer 10W1. The modified two-quantum well structure of the present embodiment is extremely suitable for completely separating only the three levels involved in the operation from the other levels and is also used in practice.

With respect to Condition 3, the second barrier layer 10B2 between the upper lasing level ULL and the lower lasing level LLL acts as a lasing barrier in the present embodiment of the THz-QCL element. Therefore, optical transitions or diagonal transitions are performed between the upper lasing level ULL and the lower lasing level LLL which are spatially separated from each other by the second barrier layer 10B2. The oscillator strength between the lasing levels can be adjusted by changing the thickness of the lasing barrier. The first barrier layer 10B1, which is the injection barrier, is designed to be thicker to block horizontal leakage.

1-3. Analysis by Numerical Simulation

In the conventional two-quantum well structure, it is impossible to isolate the three levels involved in the operation from the other levels, even if the structure is optimized. In contrast, in the present embodiment, the modified two-quantum well structure makes it possible to ensure optical gain at 340 K or higher. This is over 100 K higher than the previous system. This result was obtained by analysis using a first principle exact solution method based on the NEGF method. This numerical analysis used the parameters of the AlGaAs-GaAs material.

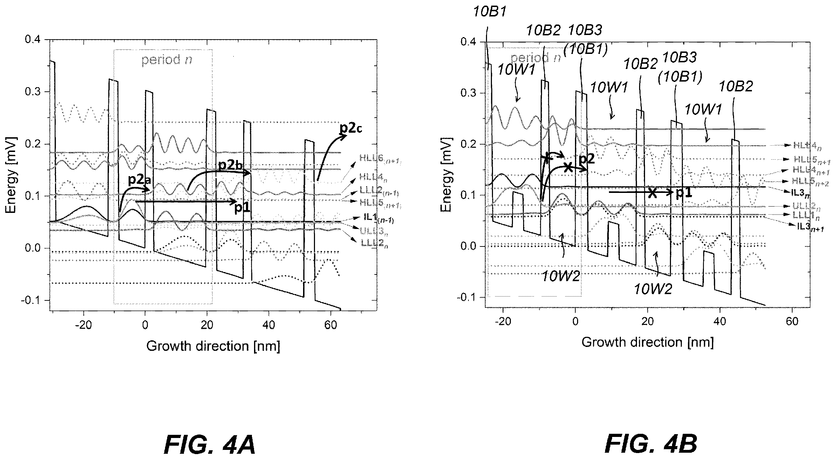

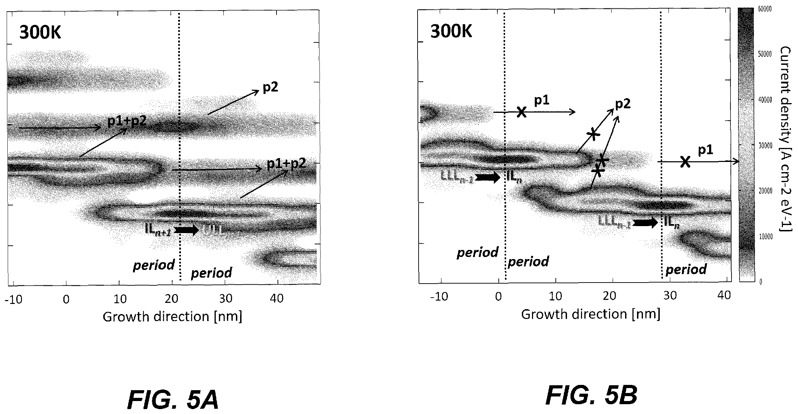

FIGS. 4A and B show the wavefunctions of the THz-QCL subband states and the conduction band edge energy (conduction band profile) at each position during operation in the conventional structure and in the present embodiment, as analyzed by theoretical calculation. The horizontal and vertical axes in FIGs. 4A and B are the same as those in FIGs. 3A and B, but the slope of the potential due to the bias electric field is explicitly shown. FIGS. 5A and B are current density distribution maps calculated for the conventional structure and the structure of the present embodiment during operation at 300 K by the same theoretical calculation. In these figures, the horizontal and vertical axes are the same as in FIGS. 4A and B. In FIGS. 4A and B, the repeated unit structure is identified as n-1, n, n+1, etc., from the upstream side of the electrons, i.e., from left to right. The wave function is shown as a positive value multiplied by its own complex conjugate to represent the distribution of the probability of finding at each position. The vertical position on the paper for the baseline of the distribution of the probability of finding at each location is drawn in line with the scale for the potential (left axis) for the energy level. Furthermore, since there are several wave functions belonging to the nth unit structure, they are distinguished by the integers 1, 2, and 3, sequentially from the lowest energy, and they are clearly indicated whether it is the upper lasing level ULL, the lower lasing level LLL, the injection level IL, or the high-lying level HLL in the emission operation of the level structure. For example, "lower lasing level $LLL2_n$" indicates that it is the wave function of the second lowest energy level belonging to the nth unit structure and that it operates as the lower lasing level LLL.

In the conventional structure of FIG. 4A, for lasing due to optical transitions between the upper lasing level $ULL3_n$ and the lower lasing level $LLL2_n$, electrons are injected from the upstream injection level $IL_{n-1}$ to the upper lasing level $ULL3_n$ and electrons are extracted from the lower lasing level $LLL2_n$ to the injection level ILn via LO phonon scattering. In this operation, the obstacle to maintaining the population inversion is the leakage from the upper lasing level ULL3n. The current mapping in FIG. 5A shows a very strong leakage at 300K. However, the direct tunnel leakage channel p1 also originates from the upper lasing level $ULL3_n$ and should not be as strong. Therefore, the strong leakage in the current image at 300 K comes from the thermal process p2. The channel p1 in FIG. 4A is due to resonances between the injection level $IL1_{n-1}$ / upper lasing level $ULL3_n$ and the high-lying level $HLL4_{n+1}$ in the next downstream cycle. The high-lying level $HLL4_{n+1}$ is the second excited state of the phonon well. The leakage channel p2 is formed by the following successive activation steps: hot electrons first escape from the upper lasing level $ULL3_n$ to the high-lying level HLL4n in the same period (p2a), then thermally jump to the high-lying level $HLL6_{n+1}$ (p2b), and finally jump out of the confined region into the continuum (p2c). Thus, although the p1 channel is mainly formed by multiple adjacent unit structures, it is clear that the p2 channel is dominant within the period.

In contrast, in the structure in the present embodiment shown in FIG. 4B, for lasing due to the optical transition between the upper lasing level $ULL2_n$ and the lower lasing level $LLL1_n$, electrons are injected vertically and indirectly from the injection level $IL3_n$ to the upper level $ULL2_n$ via LO phonon scattering, and electrons are extracted from the lower lasing level LLL1n to the injection level $IL3_{n+1}$ downstream. The obstacle to maintaining population inversion in this operation is the leakage from the upper lasing level $ULL2_n$. In the present design, the thermal leakage channel p2 is significantly suppressed due to the isolated three-level system (FIG. 4B, FIG. 5B). In addition, the tunnel leakage channel p1 is also blocked. It can be seen that all the leakage channels are blocked even at 300 K in the proposed "modified two-quantum well" structure, whereas various leakage channels exist in the conventional "two-quantum well" structure for high-temperature THz-QCL structures. Although not shown in FIGS. 3A, 3B, 4A, and 4B, appropriate dopants are added to each of the quantum well layers in the unit structure of the THz-QCL element 1000 for the required n-type conduction properties. In the present structure, only the second well layer 10W2 (Lower Well) in FIG. 3B is doped with $8 \times 10^{16}$ cm$^{-3}$ n-type Si doping, while the other layers are undoped. Analysis confirms that this value is substantially optimal for optical gain near room temperature.

Table 1 shows the calculated electron occupancy (unit: %) in the non-equilibrium state in each subband for the temperatures of 50 K and 300 K. In the conventional design for the high temperature THz-QCL structure (TW-RP), the occupancy of the high-lying level HLL ($n_{HLL}$) at 300 K is about 10% of the total electrons and can leak out of the subbands involved in the operation. In contrast, in the design for the present embodiment (This design), it is reduced to only 1%. This means that a high temperature tolerance has been confirmed with the design of this embodiment. The fact that the population inversion is maintained even with increasing temperature is due to the suppression of the high-lying level HLL population ($n_{HLL}$), which increases in the presence of leakage current, and the slowing down of the thermal phonon relaxation process.

[Table 1]

Non-equilibrium population distribution of quantum states

|  |  | $n_{ULL}$ | $n_{LLL}$ | $n_{IL}$ | $\triangle n_{ULL/LLL}$ | $n_{HLLs}$ |
|---|---|---|---|---|---|---|
| TW-RT | 50K | 45.1 | 3.8 | 50.2 | 41.3 | 0.9 |
|  | 300K | 27.2 | 19.8 | 43.1 | 7.4 | 9.9 |
| This design | 50K | 83.6 | 8.9 | 6.8 | 74.7 | 0.7 |
|  | 300K | 65.3 | 20.2 | 13.7 | 45.1 | 1.1 |

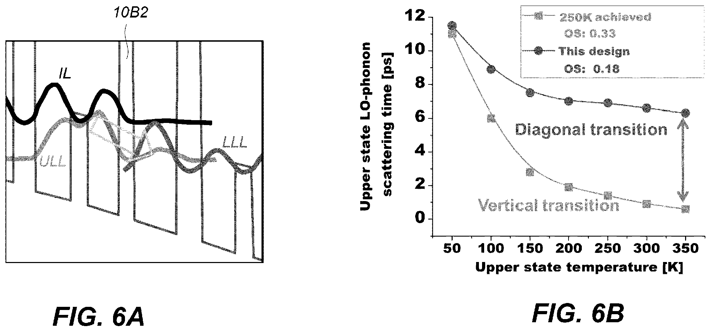

Next, the specific effects of diagonal transitions were investigated. As shown in FIG. 1B, in a situation where the electrons are under the influence of heat, such as at room temperature, they thermally relax from the upper lasing level ULL to the high-lying level HLL due to scattering to the higher energy side by the LO phonons. In addition, under the influence of heat, the electrons thermally relax from the upper lasing level ULL to the lower lasing level LLL due to scattering to the lower energy side by the LO phonons. FIG. 6A shows a schematic of the diagonal transitions of the upper lasing level ULL and the lower lasing level LLL ("upper level" and "lower level" in FIG. 6A, respectively) and the injection level IL. The diagonal transition means that the probability of finding electrons in each of the upper and lower lasing levels is distributed on both sides of the lasing barrier. Since optical transitions are accompanied by a spatial electron center-of-mass shift, the oscillator strength is associated with a decrease in oscillator strength as the degree of diagonal transition increases. FIG. 6B shows the calculated temperature dependence of the LO phonon scattering relaxation time of the upper lasing level ULL when the oscillator strength is set to 0.18 in this embodiment, which employs diagonal transitions. The horizontal axis refers to the absolute temperature of electrons in the upper lasing level ULL, and the vertical axis refers to the scattering time (relaxation rate) of electrons due to LO phonon scattering from the upper lasing level ULL. For comparison, also shown is a design example of a vertical transition in which an optical transition occurs in the same well in the design of a THz-QCL structure for high temperatures and the oscillator strength is set to 0.33 (comparative design example). In the comparative design example where the oscillator strength is set to 0.33 as the vertical transition, the LO phonon scattering relaxation time rapidly shortens as the temperature rises, and the scattering rate due to LO phonon scattering increases. In other words, it becomes difficult to maintain the population inversion. In contrast, in the present embodiment, when the oscillator strength is set to 0.18, although the LO phonon scattering relaxation time becomes shorter as the temperature rises, the degree of this decrease is moderate. Therefore, in the present embodiment, by employing the diagonal transition, leakage due to LO phonon scattering can be suppressed, and it is easy to maintain the population inversion even in high temperature environments such as room temperature.

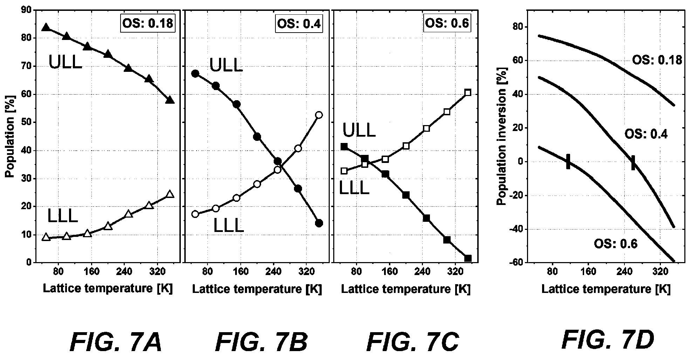

We further investigated the degree of population inversion and the optical gain obtained by varying the proportion of diagonal transitions. FIGS. 7A-C show the lattice temperature dependence of the electron population of the upper lasing level ULL and the lower lasing level LLL as the oscillator strength is varied from 0.18, 0.4, to 0.6. The oscillator strength can be tuned by adjusting the dipole matrix elements between the optical transition levels, so calculations were performed with the thickness of the second barrier layer 10B2 adjusted. The difference in the fraction occupied by the upper lasing level ULL and the lower lasing level LLL indicates a population inversion. It is confirmed that the temperature at which the population inversion is realized increases as the degree of diagonal transition is increased, i.e., as the oscillator strength is decreased. FIG. 7D is another plot of the calculated values in FIGS. 7A-C, focusing only on the difference in the fraction of the upper lasing level ULL and the lower lasing level LLL as a function of lattice temperature. A value greater than 0% of the population inversion indicates that the population inversion is realized, and less than 0 indicates that the population inversion is not realized. For oscillator strengths of 0.6 and 0.4, the upper temperature limits at which population inversion is achieved are approximately 120 K and 260 K, respectively. On the other hand, when the proportion of diagonal transitions is increased and the oscillator strength is reduced to about 0.18, the LO phonon scattering leakage channel due to thermally excited electrons is reduced, and a large population inversion (difference in electron densities between the upper lasing level ULL and the lower lasing level LLL) occurs over the entire temperature range studied. Note that when the oscillator strength is 0.6, the population inversion decreases rapidly and reaches zero at 120 K. This is because the channel through the injection level IL to the lower lasing level LLL is strongly activated, making selective injection transitions rather difficult to realize. Usually, the thinnest layer in the THz-QCL (the second barrier layer 10B2 in FIGS. 3B and 4B) is called the lasing barrier. However, this lasing barrier cannot be made too thin for vertical indirect injection. This is because the space between the injection level IL and the lower lasing level LLL is very narrow, and only the lasing barrier exists there. Between the injection level IL and the lower lasing level LLL there is a down-scattering of LO phonons. Therefore, by intentionally thickening the lasing barrier, the oscillator strength can be reduced to a smaller value.

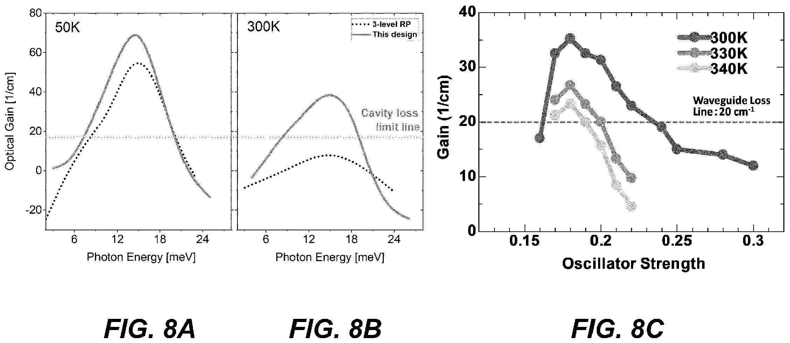

FIGS. 8A and 8B show the optical gain spectra for the conventional design for a high-temperature THz-QCL structure at low and high temperatures (50 K and 300 K) and the design of the present embodiment. The horizontal axis is the photon energy and the vertical axis is the optical gain. FIG. 8C is also a graph showing the dependence of optical gain on oscillator strength at several higher temperatures near room temperature in the present embodiment. Since the cavity loss in the THz-QCL element is about 18-20/cm, lasing operation can be expected for optical gains larger than this. In this guideline in this design, which can maintain sufficient population inversion even at room temperature; a. Suppress thermal and tunneling leakage by creating a pure level system; b. Effectively suppress a thermal LO-phonon relaxation channel from the upper lasing level ULL to the lower lasing level LLL by using a small oscillator strength (greater than 0.16 and less than 0.24), is adopted. This significantly increases the electron fraction in the upper lasing level ULL and a significant population inversion can be achieved. Changing the oscillator strength also changes the optical gain at each temperature is also changed. In this structure, only the second well layer 10W2 (Lower Well) in FIG. 3B is doped with $8 \times 10^{16}$ cm$^{-3}$ n-type Si, while the other layers are undoped. The 2D doping level in a unit structure is $4.1 \times 10^{10}$ cm$^{-2}$. Based on the temperature characteristics in FIG. 8C, the lower limit of the oscillator strength should be above 0.16, such as 0.17. The upper limit of the oscillator strength is preferably less than 0.24, more preferably 0.22, still more preferably 0.2, and still more preferably 0.19. With a typical oscillator strength of 0.17 to 0.18, sufficient optical gain can be obtained even in light emission at room temperature (340 K) or higher. However, if the oscillator strength is reduced to a lower value, such as 0.15, it is difficult to expect sufficient optical gain. One reason is that coupling between the upper lasing level ULL and the lower lasing level LLL is too weak.

It is clear that a large optical gain is obtained when a typical oscillator strength of 0.17-0.18 is used. In the present embodiment of the THz-QCL element, an optical gain of 35 cm$^{-1}$ was obtained at 300 K, which is sufficient to outweigh the waveguide loss (18 to 20 cm$^{-1}$). Therefore, room temperature lasing operation can be expected in the THz-QCL element in the present embodiment by using 0.17-0.18 as the oscillator strength.

In contrast, as shown in FIG. 8B, the optical gain of the conventional two-quantum well structure (three-level RP) can be high at 50 K, but it is about 5 cm$^{-1}$ at 300 K, and room temperature lasing cannot be achieved. Here, the results of the conventional two-quantum well structure were also obtained by optimizing as much as possible for high-temperature operation. To be more specific, even with optimization in the conventional structure with insufficient isolation, lasing operation at about 230 K (not shown in the figure) was the highest temperature. In contrast, by adopting the concept of the isolated three-level structure in the present embodiment and the device structure in which the potential of the well layer is modulated for this purpose, lasing operation up to about 340K is possible by optimizing the oscillator strength.

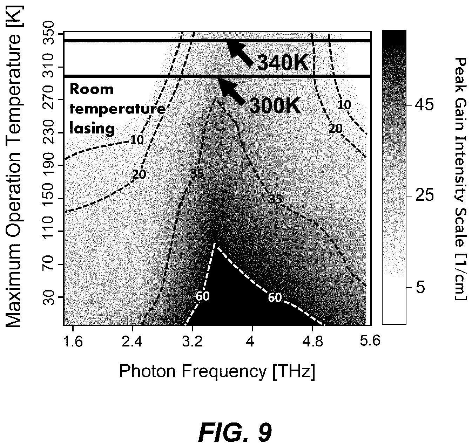

FIG. 9 is a map showing the optical gain in terms of shading as a function of photon frequency, determined from the energy difference between the lasing levels, and temperature, obtained for an oscillator strength of 0.18 in the design of the present embodiment. As mentioned above, lasing operation can be expected in the region where the optical gain is higher than the waveguide loss (18 to 20 cm$^{-1}$). The figure also shows contours by chain lines for typical values of optical gain. At a temperature of 300 K, the lasing frequency is expected to be in the range of 3.0 THz to 4.8 THz, and at a temperature of 340 K, the lasing frequency is expected to be in the range of 3.2 THz to 4.8 THz.

1-4. Choice of Materials

In the present embodiment, the numerical analysis described above used the parameters for the AlGaAs-GaAs material system. In particular, the numerical analysis reflected the selection of the material composition with the aim of suppressing, in particular, the thermally induced leakage from the desired levels (subbands) and maintaining a sufficient population inversion even at 300 K. For this purpose, high barriers were used for the first and second barrier layers 10B1 and 10B2, as shown in FIG. 3B. The value of b1 in FIG. 3B is about 300 meV. The mini-step of the convex structure created by the second sublayer 10W12 employing, for example, $Al_{0.07}Ga_{0.93}As$ allows b2 to be about 70 meV. When the convex structure is placed in the center of the first well layer 10W1, as shown in FIG. 3B, it has a significant effect of pushing up the energy to the upper lasing level ULL and the second excited state, which are odd modes, but does not have such a significant effect on the injection level IL. In other words, the convex structure is not used to confine electronic states (subbands) as in the first and second barrier layers 10B1 and 10B2, but to manipulate the relative ratio in the energy interval E1 and E2. In fact, in the structure described above, E2 can be as high as 110 meV. This value can be set to about twice the value of E2 (the energy difference between the first and second excited states of the wide side well) in the conventional structure (FIG. 3A). At the same time, E1 can be kept at about 36 meV due to the convex structure of the second sublayer 10W12. The dimensions W1, W2, W3 and the height of b2 shown in FIG. 3B are adjustable parameters. Therefore, the available degree of freedom in designing the ratio of E1 to E2 is very high. For example, the convex structure ($Al_{0.07}Ga_{0.93}As$) of the second sublayer 10W12 having a height of 70 meV in the present embodiment can be adjusted in the range of 50 meV to 100 meV by adjusting the Al composition x of $Al_xGa_{1-x}As$ from 0.05 to 0.1. The position of this convex structure can also be adjusted to W1 > W3 or W1 < W3, except for the center of the first well layer 10W1 as W1 = W3, for example. The width of the mini-step (W2) can also be made slightly thicker or thinner. The ground state of the second well layer 10W2 plays the role of the lower lasing level LLL. Since the dimensions of W4 are small, the energy difference E3 is large and the first excited state is pushed up. As a result, the energy difference E4 between the said first excited state and the lower lasing level LLL is also set to be large. In other words, the introduction of the second sublayer 10W12 or the modulation of the potential of the first well layer is useful for realizing the isolated three levels in which the high-lying level HLL shown in FIG. 1A is pushed up.

Any of the embodiments of the present disclosure can be implemented using semiconductor superlattices of AlGaAs-GaAs composition. In a typical example of such a case, assuming $0 \leq y < x < z \leq 1$, the material of the first sublayer 10W11 and the third sublayer 10W13 in the first well layer 10W1 has a composition of $Al_yGa_{1.0-y}As$, the material of the second sublayer 10W12 has a composition of $Al_xGa_{1.0-x}As$, the material of the second well layer 10W2 has a composition of $Al_yGa_{1.0-y}As$, and the material of the barrier layers B1 and B2 is selected to have composition of $Al_zGa_{1.0-z}As$.

1-5. Other Materials

Each of the embodiments of the present disclosure can be implemented with other materials. Isolated three-level structures and structures that provide convex structures within the well potential may be realized with other materials, such as InP-InGaAs-InAlAs, AlInSb-InSb, AlInSb-InAsSb, GaAsSb-InGaAs, GaAs-InGaAs, GaN-AlGaN, GaN-InGaN, AlN-AlGaN, and SiGe systems. The design guidelines and numerical results described above are not material specific, but similar trends can be expected when parameters such as potential and LO phonon energy are varied. Therefore, the novel approach of modulating the potential of the well layer, especially by providing a convex structure in the potential, is the design guideline that can be universally applied even if the material system is changed. The isolated three-level structure and its design guidelines are effective not only for non-polar crystals, but also for polar and semi-polar crystals in which a piezoelectric field can create a potential gradient.

1-6. GaN-AlGaN, GaN-InGaN, and AlN-AlGaN Systems

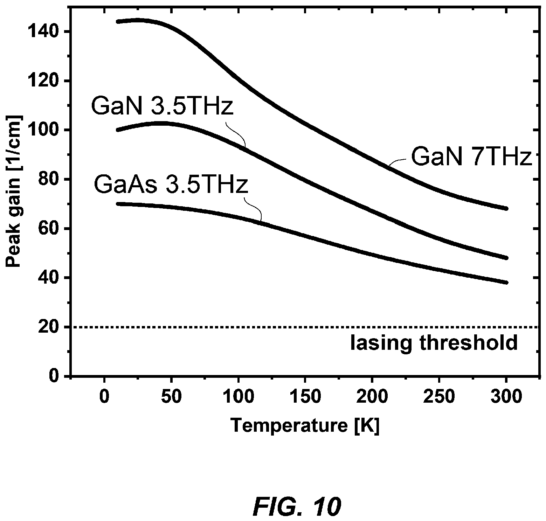

As a specific example, the structure employing GaN-AlGaN semiconductor is described considering GaN-AlGaN, GaN-InGaN, and AlN-AlGaN semiconductor materials. FIG. 10 is a graph of the gain of a THz-QCL element of the present embodiment using GaN-AlGaN-based materials at various temperatures. This structure is labeled "GaN" on the graph. In the GaN-AlGaN-based THz-QCL element, the isolated three-level structure can also be implemented by providing a convex structure within the potential of the well. The GaN-AlGaN system was designed with a non-polar crystal orientation. Here are examples of calculations for lasing frequencies of 3.5 THz and 7.0 THz. Also shown in the graph is a THz-QCL element using an AlGaAs-GaAs material with a lasing frequency of 3.5 THz for comparison. This structure is labeled "GaAs" in the graph. The vertical axis is the maximum gain obtained after adjusting the oscillator strength by changing the design parameters as shown in FIG. 8C. Therefore, the structure details, such as the thickness of the layers, are different at each temperature of each curve. As can be seen the comparison of the two THz-QCL elements in the 3.5 THz design shown in FIG. 10, the THz-QCL element in the GaN-AlGaN system exhibits higher gain over all temperature ranges compared to the AlGaAs-GaAs system. This is attributed to the advantage of the GaN-AlGaN-based semiconductor with respect to Conditions 2 and 3 described above due to the difference in the energy of the LO phonon, which is 36 meV for GaAs and 90 meV for GaN. Specifically, with respect to the condition described as Condition 2, it is useful to set the high-lying level such that the energy difference from the upper lasing level to the upper lasing level is, for example, less than 90 meV and greater than 116 meV for the GaN-AlGaN system. The value of 116 meV is 26 meV (room temperature kT) + 90 meV (energy of the LO phonons in the GaN-AlGaN system).

In addition, the GaN-AlGaN system can achieve lasing in a frequency range where lasing in the AlGaAs-GaAs system is difficult (between 5 THz and 12 THz). FIG. 10 also shows the gain at a lasing frequency of 7.0 THz for the GaN-AlGaN-based THz-QCL element. By providing a convex structure within the potential of the well in the isolated three-level structure of this embodiment in the GaN-AlGaN system, where the LO phonon energy is larger, the AlGaAs-GaAs system is expected to have good gain even in the range between 5 THz and 12 THz, where lasing operation is not possible in the AlGaAs-GaAs system.

Although the above explanation has been given using the GaN-AlGaN system as an example, high temperature operation can be expected in any semiconductor composition of the GaN-InGaN and AlN-AlGaN systems where the LO phonon energy is large, approximately 90 meV, and operation at frequencies between 5 THz and 12 THz is also possible.

In the above description, the embodiment of the present disclosure has been described specifically. Any description in this Specification is for the purpose of explaining the present disclosure, therefore the scope of the invention of this disclosure should be determined based on the recitation of the claims. In addition, other variations based on any combination of the embodiment are included in the present disclosure, which variation should also be within a scope of the claims.

Industrial Applicability

The THz-QCL with an improved ceiling of operating temperature of the present disclosure is used in devices that utilize sources of electromagnetic waves in the THz range.

Reference Signs List

    1000 element
    100 QCL structure (semiconductor superlattice structure)
    100A semiconductor superlattice structure
    10 active region
    10B, 10B1-10B3 barrier layer
    10W, 10W1 to 10W2 well layer
    10W11, 10W12, 10W13 first to third sublayers
    10U unit structure
    120, 140 Highly doped GaAs layer
    160 δ-doped GaAs layer
    20, 30 electrode
    30A, 30B metal layer
    40 receptor
    50 substrate
    60 etch stopper layer
    2000 electromagnetic wave

**Claims**

1. A quantum cascade laser element having a semiconductor superlattice structure sandwiched between a pair of electrodes,

   wherein the semiconductor superlattice structure has an active region that emits electromagnetic waves of a certain frequency in the THz range under an external voltage applied through the pair of electrodes for operation,
   wherein the active region has a plurality of unit structures that are stacked repeatedly,
   wherein each unit structure has a quantum well structure comprising a plurality of well layers separated from each other by a barrier layer, and
   wherein the quantum well structure has a subband structure of electrons in an isolated three-level structure under the external voltage.

2. The quantum cascade laser element according to claim 1,

wherein the isolated three-level structure in each unit structure includes an upper lasing level, a lower lasing level, and an injection level under the external voltage, and

wherein a selective electron injection operation from the injection level to the upper lasing level by vertical indirect injection via LO phonon scattering is performed under the external voltage.

3. The quantum cascade laser element according to claim 1 or 2,

wherein the isolated three-level structure in each unit structure includes an upper lasing level, a lower lasing level, and an injection level under the external voltage, and

wherein the upper lasing level has an energy value that is lower from upper leak levels under the external voltage by an energy difference greater than a sum of the product of the absolute temperature during operation and Boltzmann's constant and a photon energy at a lasing frequency, the upper leakage levels being not any of the upper lasing level, lower lasing level, and injection level.

4. The quantum cascade laser element according to claim 1 or 2,

wherein the isolated three-level structure in each unit structure includes an upper lasing level, a lower lasing level, and an injection level under the external voltage, and

wherein the wave function of the upper lasing level and the wave function of the lower lasing level are spatially separated from each other under the external voltage.

5. The quantum cascade laser element according to claim 4,
wherein an oscillator strength calculated from a wave function of the upper lasing level and a wave function of the lower lasing level under the external voltage is greater than 0.16 and less than 0.24.

6. The quantum cascade laser element according to claim 1 or 2,

wherein the quantum well structure has at least two quantum wells capable of forming a plurality of subbands with quantized energies of electrons, and

wherein a potential for electrons inside at least one of the at least two quantum wells is modulated according to the position in the thickness direction.

7. The quantum cascade laser element according to claim 3,

wherein material of semiconductors forming the semiconductor superlattice structure is AlGaAs-GaAs system, and

wherein the energy difference is 62 meV or more.

8. The quantum cascade laser element according to claim 3,

wherein material of semiconductors forming the semiconductor superlattice structure is GaAs-InGaAs system, and

wherein the energy difference is 116 meV or more.

9. A quantum cascade laser element having a semiconductor superlattice structure sandwiched between a pair of electrodes,

wherein the semiconductor superlattice structure has an active region that emits electromagnetic waves of a certain frequency in the THz range under the external voltage applied through the pair of electrodes for operation, wherein the active region has a plurality of unit structures that are stacked repeatedly,

Wherein each unit structure has a two-quantum well structure including a first well layer and a second well layer separated from each other by a barrier layer in the order of electron flow under the external voltage, and

wherein the potential for electrons in at least one of the first well layer or the second well layer is modulated according to the position in the thickness direction.

10. The quantum cascade laser element according to claim 9,

wherein the first well layer includes a structure in which a first sublayer, a second sublayer of different composition from the first sublayer, and a third sublayer of the same composition as the first sublayer are stacked in the order of electron flow under the external voltage, and

wherein the potential for electrons in the second sublayer is lower than the barrier height created by the potential for electrons in the barrier layer and higher than the potential for electrons in both the first sublayer and the third sublayer, and wherein the potential for electrons in the first well layer has a convex structure.

11. The quantum cascade laser element according to claim 9 or 10,

wherein an isolated three-level structure is realized under the external voltage, the isolated three-level structure including an upper lasing level, a lower lasing level, and an injection level,

wherein the upper lasing level of each unit structure is a ground state of the first well layer, and

wherein the lower lasing level and the injection level of each unit structure are a ground state of the second well layer and a first excited state of a first well layer in the next unit structure downstream for electrons under the external voltage.

12. The quantum cascade laser element according to claim 11, wherein a selective electron injection operation from the injection level to the upper lasing level is performed by vertical indirect injection via LO phonon scattering under the external voltage.

13. The quantum cascade laser element according to claim 11, wherein the quantum cascade laser element of claim 13, wherein the upper lasing level has, under the external voltage, an energy that is lower from upper leakage levels, which are levels that are not any of the upper lasing level, the lower lasing level, or the injection level, by an energy difference greater than the sum of a product of absolute temperature at operation and Boltzmann's constant and a photon energy at the lasing frequency.

14. The quantum cascade laser element according to claim 11, wherein a wave function of the upper lasing level and a wave function of the lower lasing level are spatially separated from each other by the barrier layer under the external voltage.

15. The quantum cascade laser element according to claim 11, wherein a barrier height of the second sublayer of each unit structure is higher than an energy value of the upper lasing level and lower than an energy value of the injection level under the external voltage.

16. The quantum cascade laser element according to any of claims 1, 2, 9 or 10, wherein a semiconductor material comprising the semiconductor superlattice structure is any one of a composition group consisting of AlGaAs-GaAs system, InP-InGaAs-InAlAs system, AlInSb-InSb system, AlInSb-InAsSb system, GaAsSb-InGaAs system, GaAs-InGaAs system, GaN-AlGaN system, GaN-InGaN system, AlN-AlGaN system, and SiGe system.

17. The quantum cascade laser element according to any of claims 1, 2, 9 or 10, wherein a lasing frequency is between 3 THz and 4 THz, inclusive.

18. The quantum cascade laser element according to any of claims 1, 2, 9 or 10, wherein a lasing frequency is between 5 THz and 12 THz, inclusive.

Push up

(1)

High-lying state

IL

(1)

LO-phonon (4)

(1)

(3)

Push up

High-lying state

ULL

(2)

THz
Lasing

LLL

IL

ULL

THz
Lasing

LLL

IL

ULL

Period n

Period n+1

## FIG. 1A

High-lying level
(HLL)

e/LO-phonon interaction
[Phonon absorption]

~36meV

Upper lasing level
(ULL)

(1)

26meV
@300K

Lower lasing level
(LLL)

e/LO-phonon interaction
[Phonon emission]

(2)

~36meV

THz
(15meV)

## FIG. 1B

**FIG. 2A**

**FIG. 2B**

**FIG. 2C**

FIG. 3B

FIG. 3A

FIG. 4B

FIG. 4A

Current density [A cm-2 eV-1]

FIG. 5B

FIG. 5A

*FIG. 6B*

*FIG. 6A*

FIG. 7A   FIG. 7B   FIG. 7C   FIG. 7D

**FIG. 8A**    **FIG. 8B**    **FIG. 8C**

**FIG. 9**

**FIG. 10**

## INTERNATIONAL SEARCH REPORT

| International application No. |
| --- |
| **PCT/JP2022/022136** |

**A. CLASSIFICATION OF SUBJECT MATTER**

*H01S 5/343*(2006.01)i
FI: H01S5/343 610

According to International Patent Classification (IPC) or to both national classification and IPC

**B. FIELDS SEARCHED**

Minimum documentation searched (classification system followed by classification symbols)

H01S5/343

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

Science Direct; IEEE Xplore; Wiley Online Library; SPIE Digital Library; Google Scholar

**C. DOCUMENTS CONSIDERED TO BE RELEVANT**

| Category* | Citation of document, with indication, where appropriate, of the relevant passages | Relevant to claim No. |
| --- | --- | --- |
| X | JP 2019-153652 A (INSTITUTE OF PHYSICAL & CHEMICAL RESEARCH) 12 September 2019 (2019-09-12) paragraphs [0002]-[0010], [0015]-[0036], [0043], fig. 1-10 | 9, 16-18 |
| Y | | 10 |
| A | | 1-8, 11-15 |
| Y | MATYAS, Alpar et al. Improved terahertz quantum cascade laser with variable height barriers. Journal of Applied Physics. 21 May 2012, vol. 111, 103106 (6 pages) II. Improved designs, fig. 2(a), 3 | 10 |
| A | | 1-9, 11-18 |
| A | US 8699535 B1 (THE UNITED STATES OF AMERICA AS REPRESENTED BY THE SECRETARY OF THE NAVY) 15 April 2014 (2014-04-15) entire text, all drawings | 1-18 |

☑ Further documents are listed in the continuation of Box C.     ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **15 August 2022** | **30 August 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

## INTERNATIONAL SEARCH REPORT

International application No.

**PCT/JP2022/022136**

### C.    DOCUMENTS CONSIDERED TO BE RELEVANT

| Category* | Citation of document, with indication, where appropriate, of the relevant passages | Relevant to claim No. |
|---|---|---|
| A | USHAKOV, D.V. et al. Study of Methods for Lowering the Lasing Frequency of a Terahertz Quantum-Cascade Laser Based on Two Quantum Wells. Semiconductors. 25 April 2012, vol. 46, no. 11, pages 1402-1406<br>entire text, all drawings | 1-18 |
| A | GRECK, Peter et al. Efficient method for the calculation of dissipative quantum transport in quantum cascade lasers. Optics Express. 03 March 2015, vol. 23, no. 5, pages 6587-6600<br>entire text, all drawings | 1-18 |
| A | SIRKELI, Vadim P. et al. Room-temperature terahertz emission from ZnSe-based quantum cascade structures: A simulation study. Physica Status Solidi RRL. 30 January 2017, vol. 11, no. 3, 1600423 (4 pages)<br>entire text, all drawings | 1-18 |
| A | LIN, Tsung-Tse et al. Variable Barrier Height AlGaAs/GaAs Quantum Cascade Laser Operating at 3.7THz. Physica Status Solidi A. 27 December 2017, vol. 2018, no. 215, 1700424 (4 pages)<br>entire text, all drawings | 1-18 |
| A | JP 2009-302379 A (CANON INCORPORATED) 24 December 2009 (2009-12-24)<br>entire text, all drawings | 1-18 |
| A | JP 2019-9348 A (SUMITOMO ELECTRIC IND., LIMITED) 17 January 2019 (2019-01-17)<br>entire text, all drawings | 1-18 |
| A | JP 2015-88630 A (INSTITUTE OF PHYSICAL & CHEMICAL RESEARCH) 07 May 2015 (2015-05-07)<br>entire text, all drawings | 1-18 |
| P, X | WANG, Li et al. Leakages suppression by isolating the desired quantum levels for high-temperature terahertz quantum cascade lasers. Scientific Reports. 08 December 2021, vol. 11, 23634 (8 pages)<br>results and discussions, fig. 1-5 | 1-4, 6, 9-17 |

Form PCT/ISA/210 (second sheet) (January 2015)

**INTERNATIONAL SEARCH REPORT**
Information on patent family members

International application No.

**PCT/JP2022/022136**

| Patent document cited in search report | | | Publication date (day/month/year) | Patent family member(s) | | | Publication date (day/month/year) |
|---|---|---|---|---|---|---|---|
| JP | 2019-153652 | A | 12 September 2019 | US paragraphs [0002]-[0014], [0035]-[0060], [0069], fig. 1-10 EP | 2019/0273363 3534469 | A1 A1 | |
| US | 8699535 | B1 | 15 April 2014 | (Family: none) | | | |
| JP | 2009-302379 | A | 24 December 2009 | US entire text, all drawings | 2009/0310639 | A1 | |
| JP | 2019-9348 | A | 17 January 2019 | US entire text, all drawings | 2018/0366912 | A1 | |
| JP | 2015-88630 | A | 07 May 2015 | US entire text, all drawings | 2015/0117485 | A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019153652 A

**Non-patent literature cited in the description**

- **KHALATPOUR, A. ; PAULSEN, A.K. ; DEIMERT, C. et al.** High-power portable terahertz laser systems. *Nature Photonics,* 02 November 2020, vol. 15, 16-20

- **L. BOSCO ; M. FRANCKIE ; G. SCALARI ; M. BECK ; A. WACKER ; J. FAIST.** Thermoelectrically cooled THz quantum cascade laser operating up to 210K. *Appl. Phys. Lett.,* 01 July 2019, vol. 115, 010601